# EUROPEAN PATENT SPECIFICATION

(11) **EP 3 188 260 B1**
(45) Date of publication and mention of the grant of the patent: **12.02.2020**
(21) Application number: 16206031.3
(22) Date of filing: 21.12.2016
(51) Int. Cl.: H01L 33/22, H01L 33/50, H01L 33/00, C09K 11/02, B82Y 20/00, C09K 11/88, G02B 1/00, B82Y 40/00

(54) **NANOSTRUCTURE MATERIAL STRUCTURES AND METHODS**
NANOSTRUKTURMATERIALSTRUKTUREN UND VERFAHREN
STRUCTURES ET PROCÉDÉS DE MATÉRIAU À NANOSTRUCTURE

(30) Priority: 31.12.2015 US 201562273749 P
(43) Date of publication of application: 05.07.2017
(73) Proprietor: Dow Global Technologies Llc, Midland, MI 48674 (US); Rohm and Haas Electronic Materials LLC, Marlborough, MA 01752 (US); The Board Of Trustees Of The University Of Illinois, Urbana, IL 61801-2901 (US)
(72) Inventor: CUNNINGHAM, Brian, Champaign, IL Illinois 61822 (US); SEE, Gloria G., Champaign, IL Illinois 61820 (US); TREFONAS, Peter, Medway, MA Massachusetts 02053 (US); ZHANG, Jieqian, Southborough, MA Massachusetts 01772 (US); PARK, Jong K., Marlborough, MA Massachusetts 01752 (US); HOWARD, Kevin, Urbana, IL Illinois 61801 (US); DESHPANDE, Kishori, Lake Jackson, TX Texas 77566 (US); TREVOR, Ewers, Marlborough, MA Massachusetts 01752 (US)
(74) Representative: Houghton, Mark Phillip

(56) References cited:
- WO-A1-2015/019220
- US-A1- 2006 192 225
- US-A1- 2007 237 479
- US-A1- 2010 126 567
- US-A1- 2013 328 066
- US-A1- 2015 349 194

## Description

### 1. Field

In one aspect, we now provide a structure that comprises a photonic crystal comprising a dielectric layer comprising therein one or more light-emitting nanostructure materials. In a further aspect, structures are provided that comprise a dielectric layer comprising first and second sets of light-emitting nanostructure materials at differing depths within the dielectric layer.

### 2. Background

There are a broad range of application-specific needs for lighting and display technologies used in homes, workplaces and consumer products. Lighting and display applications require color purity and tailored control of the optical properties of their output. For example, the directivity or diffusivity of a light source affects user comfort under various lighting conditions and the directionality of light output from displays affects the viewing angle, allowing either privacy or accessibility to groups.

Photon-emitting devices that contain quantum dots are gaining importance for application in lighting and video display due to their high quantum efficiency, lack of photobleaching and availability of many emission wavelengths that can be combined to engineer a specific overall spectral output.

US2006/192225 discloses a light emitting device and method for fabricating the device utilizes a layer of photonic crystals with embedded photoluminescent material over a light source. The layer of photonic crystals with the embedded photoluminescent material can be used in different types of light emitting devices, such as lead frame-mounted light emitting diodes (LEDs) and surface mount LEDs with or without reflector cups. WO2015/019220 discloses an illumination device comprising an energy source for exciting a photon emitter; a first wavelength conversion layer and a second wavelength conversion layer. At least one of the first and second wavelength conversion layer comprises a periodic plasmonic antenna array comprising a plurality of individual antenna elements. The wavelength converting medium in the wavelength conversion layer in which the antenna array is arranged comprises photon emitters arranged in close proximity of the plasmonic antenna array such that at least a portion of photons emitted from the wavelength conversion layer are emitted by a coupled system comprising the photon emitter and the plasmonic antenna array. US2015/349194 discloses a substrate having a first surface and a second surface; and a polymeric layer disposed on the first surface of the substrate, the polymeric layer comprising a polymer and a plurality of light-emitting nanocrystals; the polymeric layer having a patterned surface, the patterned surface having a patterned first region having a first plurality of recesses and a patterned second region having a second plurality of recesses, wherein the plurality of recesses in each region has a first periodicity in a first direction, and a second periodicity in a second direction which intersects the first direction, wherein the first periodicity of the first region is different from the first periodicity of the second region.

It would be desirable to have improved light-emitting structures, including improved quantum dot devices.

### SUMMARY

The invention is set out in accordance with the appended claims. We now provide new light-emitting structures and devices, and methods of making such structures and devices.

In one aspect, we now provide a structure that comprises a photonic crystal comprising a dielectric layer comprising therein one or more light-emitting nanostructure materials. In preferred aspects, a photonic crystal comprises periodic variations of differing (e.g. relative higher and lower) refractive index materials that can provide effective contrast.

In a further aspect, and according to the claimed invention, structures are provided that comprise a dielectric layer comprising therein light-emitting nanostructure materials, wherein a first set of light-emitting nanostructure materials are positioned at a first depth level of the dielectric layer, and a second set of light-emitting nanostructure materials are positioned at a second depth level of the dielectric layer that is distinct from the first depth level. In the embodiments according to the invention, the emission wavelengths may suitably differ between the first and second sets of light-emitting nanostructure materials. Thus, in certain embodiments, the first and second sets of light-emitting nanostructure materials are different compositions. In certain preferred embodiments, the first and second sets of nanostructure materials are separated by a thickness (e.g. 1 nm, 2 nm, 3nm, 4 nm, 5 nm thickness or more) of dielectric layer that is free or at least substantially free of light-emitting nanostructure materials. The interposing dielectric material is at least substantially free of light-emitting nanostructure material where the interposing dielectric material contains at least 25, 50, 75 or 100 weight percent less nanostructure material in a given volume than nanostructure material present in the same volume of an adjacent region that contains a first set of light-emitting nanostructure materials or a second set of light-emitting nanostructure materials.

In preferred systems, nanostructure materials are embedded within a dielectric material layer. As referred to herein, a nanostructure material can be considered embedded within a dielectric layer when each surface of a nanostructure material is in contact with a differing dielectric material.

We also provide methods that include desired placement of nanostructure materials within a dielectric layer of a photonic crystal. In particular, systems and methods of the invention provide for incorporating nanostructure materials such as quantum dots into a defined cross section of a high refractive index dielectric film layer, including within the spatial volume of an optical standing wave mode of a photonic crystal structure. In targeted positioning of nanostructure materials such as quantum dots within a dielectric layer of a photonic crystal, the nanostructure materials can experience greater electric fields for excitation from their electronic ground state as well as enable extraction of their emission most efficiently in the direction normal to the photonic crystal slab surface.

In particular, we have found substantial increases (including increases of 3 to 5 times) in quantum dot emission of a photonic crystal with the quantum dots embedded within a dielectric layer relative to a comparative planar structure (not photonic crystal). Even greater emission enhancements (e.g., up to 8-fold increase) for off-normal output angles have been observed for photonic crystals of the invention with embedded quantum dots relative to a comparative planar structure (not photonic crystal).

Preferred methods of the invention for providing a photonic crystal system in general include applying on a substrate surface a layer having one or more light-emitting nanostructure materials disposed with one or more dielectric materials. In the method according to the invention of forming a photonic crystal, 1) a dielectric material is applied on the substrate, 2) one or more nanostructure materials are applied on the applied dielectric material, and 3) a dielectric material is applied over the applied nanostructure materials.

Particularly preferred methods of the invention include dip or immersion coating application of one or more nanostructure materials onto a dielectric film. It has been found that such dip or immersion coating of a fluid composition of nanostructure materials can provide a monolayer-scale layer of the nanostructure materials.

A variety of structures and devices may be provided in accordance with the invention, including single dimension, two-dimensional and other multiple-dimensional photonic crystal structures. For instance, in one aspect, structures of the invention may include a photonic crystal that comprises a dielectric layer (e.g. metal oxide) wherein within such dielectric layer one or more light-emitting nanostructure materials are embedded, and the photonic crystal comprises 1) a first region that comprises a first periodicity in a first direction and 2) a second periodicity in a second direction that is different than the first direction.

Structures and devices provided herein also comprise multiple structures nested together, for example a plurality of structures that may comprise the same or different photonic crystals vertically stacked and/or laterally interleaved. Such structures, devices or photonic crystal systems suitably comprise multiple photonic crystal structures nested together, each photonic crystal structure comprising a dielectric layer comprising within the dielectric layer one or more light-emitting nanostructure materials. Such structures, devices or photonic crystal systems suitably may provide differing nanostructure materials at differing depths within one or more dielectric layers.

In certain aspects, preferred structures of the invention can provide an output emission that is increased relative to a control structure, e.g. increased by 40, 50, 100, 200, 300, 400, 500, 600, 700, 800 percent or more. A control structure would be comparable to a structure of the invention and contain the same dielectric layer and light-emitting nanostructure materials as the structure of the invention, but the control structure would be a planar structure (not photonic crystal).

In preferred methods, a polymeric layer may be deposited onto a molding master substrate to define device features, including a periodic pattern for the photonic crystal. After deposition on such a molding substrate, the polymeric layer may be removed from the substrate and the removed polymeric layer transferred to a distinct substrate. Suitably, after deposition onto a molding substrate or other substrate, the polymeric layer may be cured such as by thermal treatment.

One or more nanostructure materials may be positioned within a variety of structure locations. Suitably, one or more nanostructure materials are positioned proximate to the refractive index differential interface of the structure to thereby provide an effective emission output.

The invention also provides devices obtained or obtainable by the methods disclosed herein, including a variety of light-emitting devices, photodetectors, chemical sensors, photovoltaic device (e.g. a solar cell), transistors and diodes, biological sensors, pathological detectors as well as biologically active surfaces that comprise the systems disclosed herein.

As referred to herein, nanostructure materials include, among others, quantum dot materials as well as without limitation nanocrystalline nanoparticles, dyes and phosphors.

As used herein, the terms "a", "an", and "the" include plural forms unless the context clearly dictates otherwise. Thus, "a", "an", and "the" each refer to "one or more" unless the context clearly dictates otherwise.

Unless specifically stated or obvious from context, as used herein, the term "or" is understood to be inclusive.

Other aspects of the invention are disclosed infra.

### BRIEF DESCRIPTION OF THE DRAWINGS

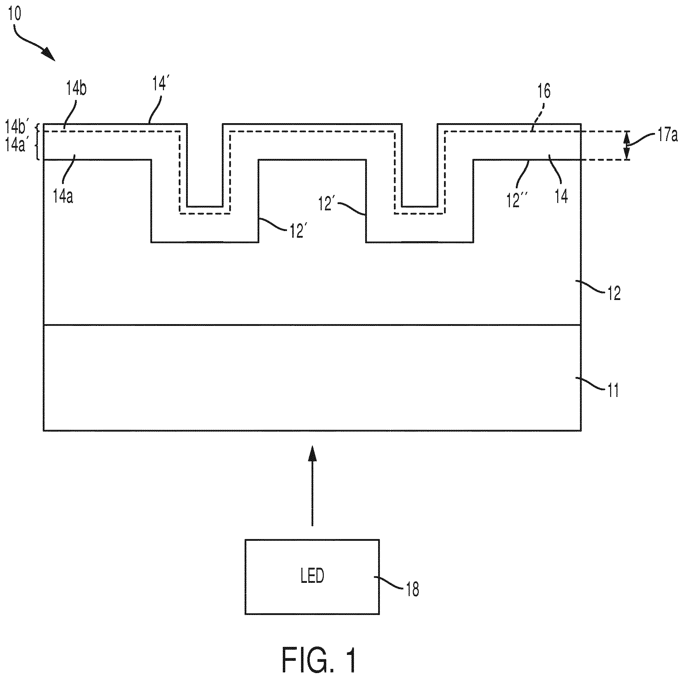

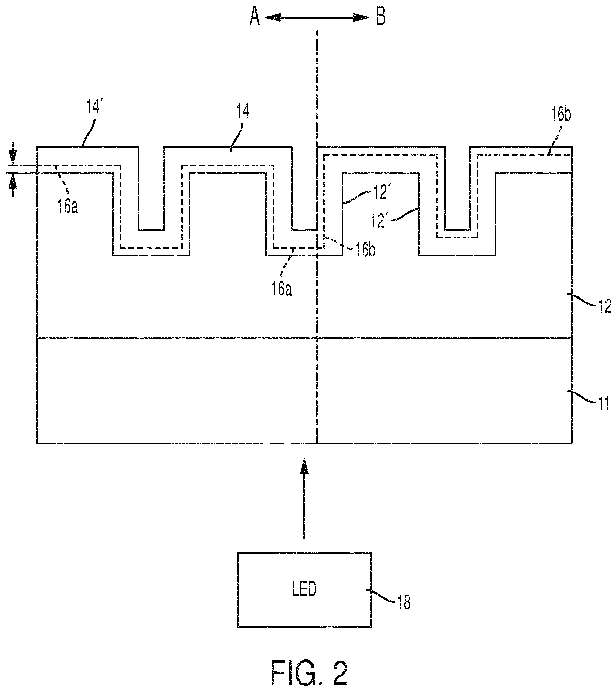

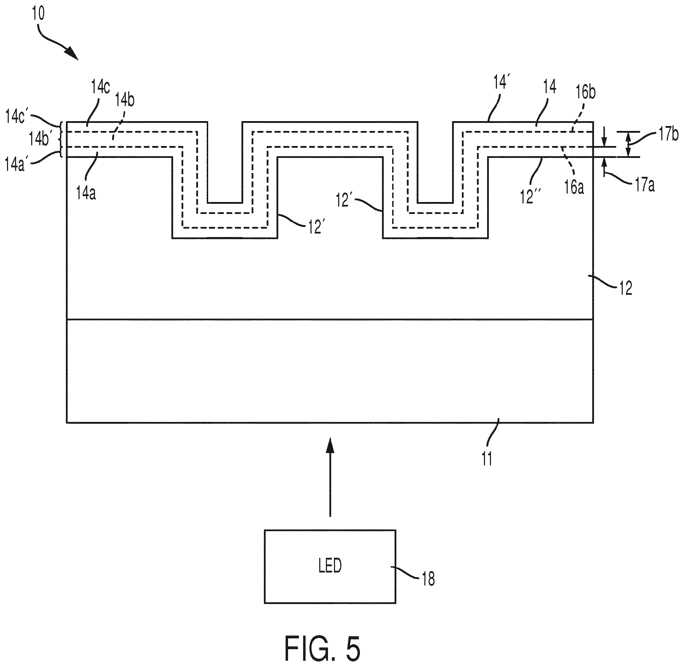

Figures 1 and 5 show exemplary devices related to the present invention. Figures 2, 3 and 4 show devices according to the present invention.

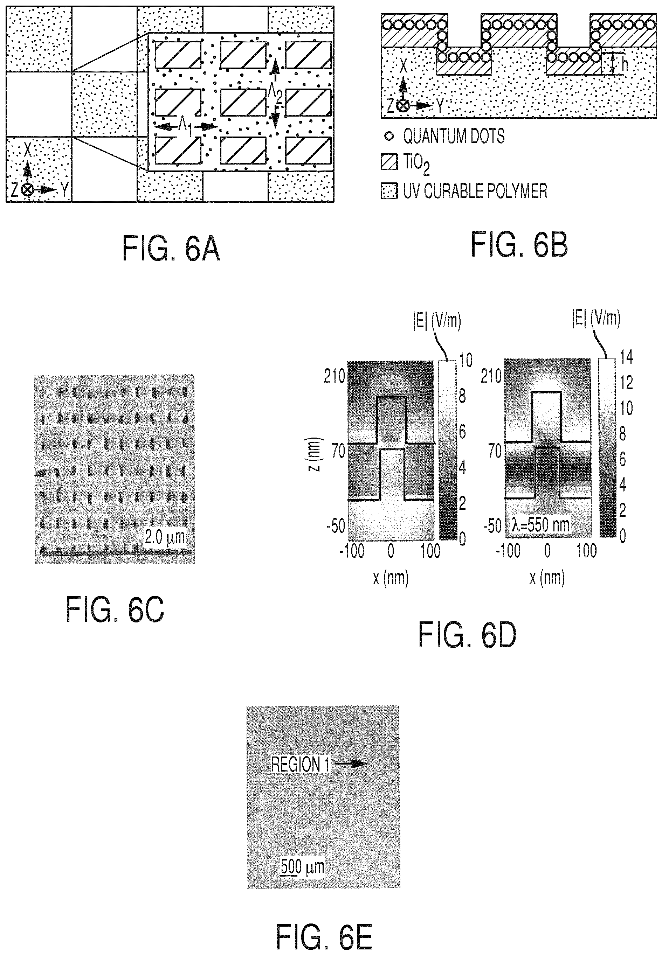

Figure 6 (which includes Figures 6(a), (b), (c), (d) and (e) shows various depictions of the device of Example 1 which follows. Figure 6(a) is a top view of the device structure of Example 1 which follows and shows two interleaved regions with different photonic crystal (PC) periods in the *x* and *y* directions. Figure 6(b) is a cross-section schematic of the photonic crystal (PC) with quantum dots (QDs) embedded in the TiO₂ dielectric layer. Figure 6(c) is a scanning electron micrograph (SEM) image of the PC region designed to enhance QD emission at λ=615 nm. Figure 6(d) shows modeled electric field intensities for the PC at λ=615 nm (left) and λ=550 nm (right), illustrating that both the wavelength and location of the QDs within the electric field will affect the enhancement conditions. Figure 6(e) is a photograph of QDs embedded in the checkerboard PC structure, where the orange locations show regions of enhanced emission (Region 1), while the QD emission in Region 2 and the surrounding bulk area is not enhanced.

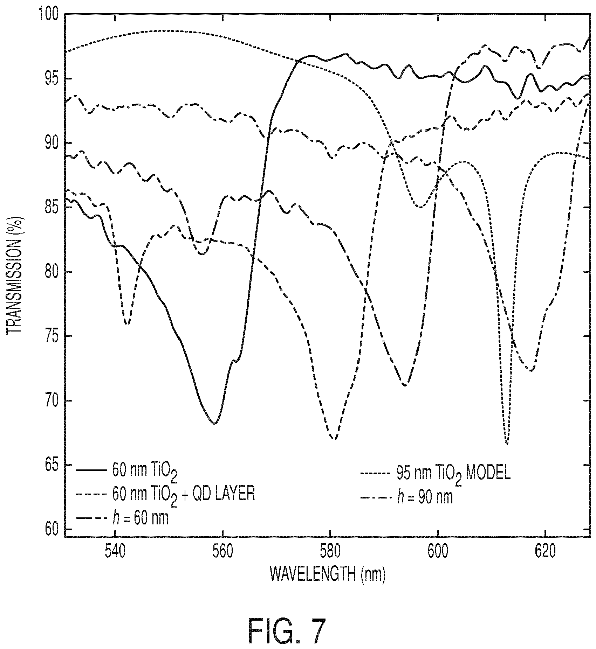

Figure 7 shows normalized transmission efficiency spectra of the PCs at various stages of fabrication and the modeled transmission spectra normalized for the 50% effective area of the checkerboard device. The largest dip in the resonance mode is intended to couple with the QD emission, although additional resonances are present in the structure, which are observed as shallower dips in the transmission spectra. The addition of a QD layer results in a resonance shift of λ=20-25 nm and disrupts the continuous electric field within the dielectric layer, causing a change in the measured resonance conditions of the final device structure, as compared to the modeled results.

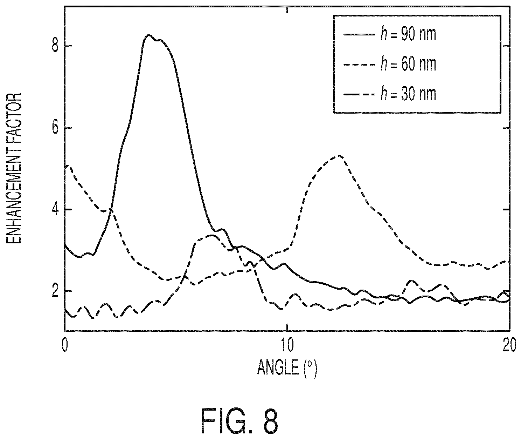

Figure 8 shows the PC-enhanced output of QD emission at λ=615 nm, as compared to planar structures with identical fabrication steps. The location of the QD layer in the structure affects both the intensity and angular output of the measured emission. The largest enhancement occurred for QDs embedded at *h*=60 nm within the TiO₂ layer; however the only enhancement factor at normal incidence occurred at *h*=90 nm.

### DETAILED DESCRIPTION

We now demonstrate that deposition of nanostructure materials including quantum dots within a dielectric layer of a photonic crystal can enhance emission of the nanostructure materials. Thus, for instance, as shown in the examples which follow, liquid phase application of quantum dots can permit targeted depth placement of the quantum dots within the dielectric film layer. Enhanced emission of the quantum dots can be achieved by placement of the quantum dots at a specific depth within the dielectric film. In a photonic crystal, the depth of the quantum dots within a dielectric layer was found to modulate the resonant wavelength of the photonic crystal as well as the emission enhancement efficiency, as the semiconducting material embedded within the dielectric changes its spatial overlap with the resonant mode.

Preferred structures may include a first substrate layer (e.g. a layer of glass, polymer or other material) with an adjacent or overcoated dielectric layer comprising one more embedded nanostructure materials. The first layer and the dielectric layer suitably have differing refractive indices to provide effective contrast. As discussed above, in preferred aspects, a photonic crystal may comprise periodic variations of differing (relative higher and lower) refractive index materials that can provide effective contrast.

Referring now to the drawings, Figure 1 of the drawings is a schematic of a device or structure 10 that includes polymer layer 12 on substrate 11. Layer 12 suitably is replica molded from a molding substrate. Dielectric material layer 14 is embedded with nanostructure materials 16 such as light-emitting quantum dots. As discussed above, a nanostructure material can be considered embedded within a dielectric layer when each surface of a nanostructure material is in contact with a differing dielectric material. For instance, a nanostructure material may be coated with at least a 0.2, 0.5 or 1 nm thickness of a dielectric material (e.g. a metal oxide such as TiO₂).

Layer 14 provides a refractive index differential with respect to layer 12 to thereby provide effective contrast. Thus, layer 14 may have a refractive index that is lower than the refractive index of layer 12, or layer 14 may have a refractive index that is higher than the refractive index of layer 12. For at least certain applications, preferred materials for the layer 14 include titanium dioxide (TiO₂) or other suitable high refractive index inorganic oxides. Suitable dielectrics include e.g. metal oxides as well as related sulfur and/or selenium materials. The layer 14 can be deposited by coating (e.g., spin coating, spray coating, dip coating), sputtering, or other methods for depositing a layer of material on the polymeric layer without disturbing the patterning of the polymeric layer 12. The thickness of the layer 14 can be used to tune the resonant wavelength of the periodic recesses. When the layer 14 is TiO₂, a suitable thickness is from about 50 nm to about 500 nm.

Light source 18 shown in Figure 1 (also as light source 18 is shown in each of Figures 2 through 5) can be any suitable source of ultraviolet (UV) or visible light, e.g., light in the range of 200 nm < λ < 700 nm including an LED.

Substrate 11 can be made of any rigid or flexible material, suitably a material that is optically transparent in a desired wavelength range. For example, the substrate can be made of glass, cellulose acetate, or polymeric materials such as polyethylene terephthalate, polyimides, polycarbonate, polyurethane, and the like. The substrate can have any suitable thickness, for example, from 1 micron to 1 mm in thickness.

The one or more of the polymers of layer 12 can be selected from any suitable polymeric material, including polyethylene terephthalate, polyimides, polycarbonate, polyurethane, and the like. Preferred polymeric materials include lauryl methacrylate (LMA), ethyl glycol dimethacrylate (EGDMA) and mixtures thereof. The polymer layer can optionally be adhered to the substrate with an optically transparent adhesive such as NOA 61 (Norland Products, Inc.).

To provide a photonic crystal structure, the device can include a periodic pattern, including in the polymer layer, the substrate layer and/or dielectric layer.

Thus, polymer layer 12 suitably can be patterned, e.g. the layer 12 may comprise a plurality of recesses 12'. Recesses as referred herein can comprise periodic structures having a variety of configurations such as linear prisms, elongated ridges, and linear gratings. In a patterned region, preferably a plurality of recesses has periodicity, e.g., the plurality of recesses are spaced equally or other regular or repeating arrangement along a specified dimension on the surface. The plurality of recesses can be formed integrally with the polymeric layer, e.g., by coating a polymer solution onto a patterned master template. Alternatively, the plurality of recesses can be formed by first forming a substantially flat or planar polymer layer on the substrate, and then patterning the polymeric layer, e.g., by stamping with a patterned die. In a further alternative, microstructures such as ridges, lenslets, pyramids, trapezoids, round or square shaped posts, or curved sided cone structures (see, e.g., U.S. Patent Application 2010/0128351) are formed or applied on the polymeric layer by deposition of a material on the surface of the polymeric layer, thereby defining the plurality of recesses on the polymeric layer.

The recesses can suitably be integrally formed with the substrate or in a layer applied to the substrate. For instance, the recesses can be formed on the substrate by applying to the substrate a coating layer and subsequently patterning the applied layer.

The thickness of each portion of a dielectric layer (exemplified as 14a and 14b in Figure 1) can suitably vary. Each such dielectric layer portion thickness (shown as 14a', 14b in Figure 1) can differ and be selected for enhanced emission of interposing nanostructure material layer 16. For instance, nanostructure material layer 16 can be positioned a distance 17a from polymer layer 12 by selecting the thickness 14a' of dielectric layer portion 14a. Precise deposition of a selected dielectric layer portion thickness can be achieved by a variety of application techniques, including sputtering.

Exemplary suitable dielectric layer portion thicknesses between an underlying substrate surface (such as the thickness between surface 12" of polymer layer 12 and a nanostructure material layer 16) may suitably vary widely and include for example from about 1nm to about 1000 nm, more typically from about 2 or 3 nm to about 100, 150 or 200 nm.

Exemplary suitable top dielectric layer portion thicknesses 14b' between a nanostructure material layer 16 and top surface 14' of a dielectric layer also may suitably vary widely and include for example from about 1 nm to about 1000 nm, more typically from about 2 or 3 nm to about 100, 150 or 200 nm.

Figure 2 of the drawings shows a device or structure of the invention that includes polymer layer 12 on substrate 11. Layer 12 suitably is replica molded on a molding substrate. Dielectric material layer 14 is embedded with nanostructure materials 16 such as light-emitting quantum dots. As discussed with respect to the device shown in Figure 1, layer 14 provides a refractive index differential with respect to layer 12 to thereby provide effective contrast. Thus, layer 14 may have a refractive index that is lower than the refractive index of layer 12, or layer 14 may have a refractive index that is higher than the refractive index of layer 12. For at least certain applications, preferred materials for the layer 14 include titanium dioxide (TiO₂) or other suitable high refractive index inorganic oxide.

Device 10 of Figure 2 has multiple regions (exemplified as A and B) that have nanostructure material layers with multiple nanostructure materials 16a and 16b that differ in one or more respects, for example where the nanostructure material layer differs in depth placement within the dielectric layer 14 and/or the type or mixture nanostructure materials present within the layer are different between the multiple regions of the device. For instance, in the device exemplified in Figure 2, Region A (i.e. the left side of the device extending to hashed vertical line) may have a first type of nanostructure materials (e.g., red emitting quantum dots) that are positioned at a depth 16a as shown in Figure 2 (i.e. thickness of dielectric layer 14 to the layer 16a). Region B (i.e. the left side of the device extending to hashed vertical line) may have a second type of nanostructure materials (e.g. blue emitting quantum dots) that are distinct from the Region A first set of nanostructure materials and are positioned at a depth 16b (i.e. thickness of dielectric layer 14 to the layer 16b) as shown in Figure 2.

By such a multiple region configuration as shown in Figure 2, differing nanostructure materials can be selectively positioned within a dielectric layer to provide optimal output of the nanostructure materials. It also can be seen that the configuration of Figure 2 provides a dielectric layer that comprises first and second nanostructure materials at differing depths within the dielectric layer. The first and second nanostructure materials suitably may be the same or different.

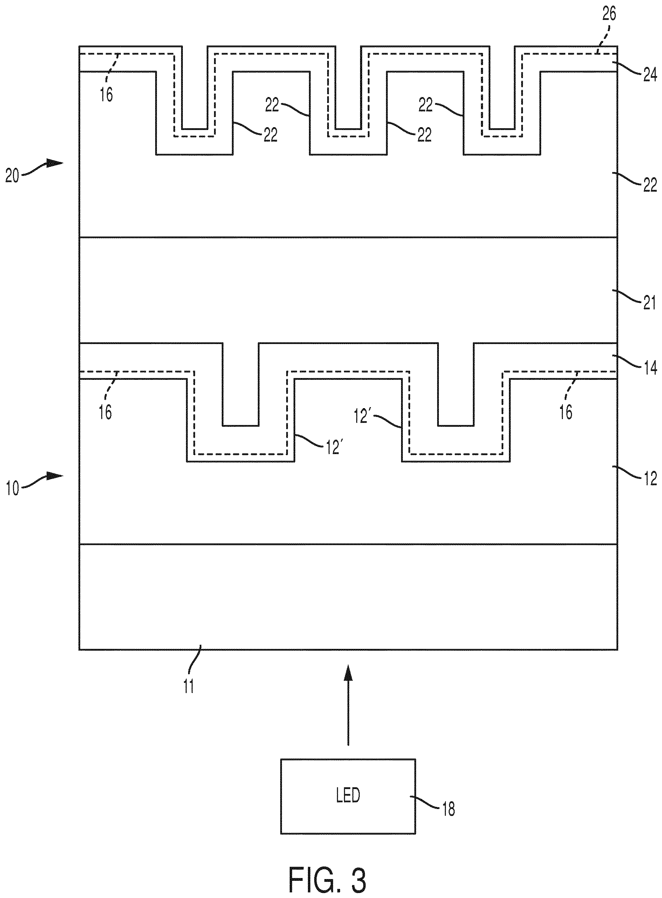

Figure 3 exemplifies another suitable configuration where multiple devices or structures 10 and 20 are nested together, particularly vertically stacked as depicted. In Figure 3, device 10 includes substrate layer 11 over which is coated polymer layer 12 with recesses 12'. Dielectric layer 14 (e.g. layer comprising TiO₂ or other suitable material such as other metal oxide to provide a desired refractive index differential) is coated over the polymer layer 12. Nanostructure materials 16 such as quantum dots are embedded within the dielectric layer 14 suitably by procedures as disclosed above with respect to Figures 1 and 2. Substrate 21 of device 20 then overlays dielectric layer 14 following by polymer layer 22 of device 20 and then dielectric layer 24 (e.g. layer comprising TiO₂ or other suitable material such as other metal oxide to provide a desired refractive index differential) is coated over polymer layer 22 with recesses 22'. Nanostructure materials 26 such as quantum dots are embedded within the dielectric layer 24 suitably by procedures as disclosed above with respect to Figure 1 and 2.

As should be understood, additional devices or structures can be nested together with those depicted in Figure 3, for instance nesting adjoining devices either laterally and/or further vertically with respect to the exemplary devices depicted in Figure 3.

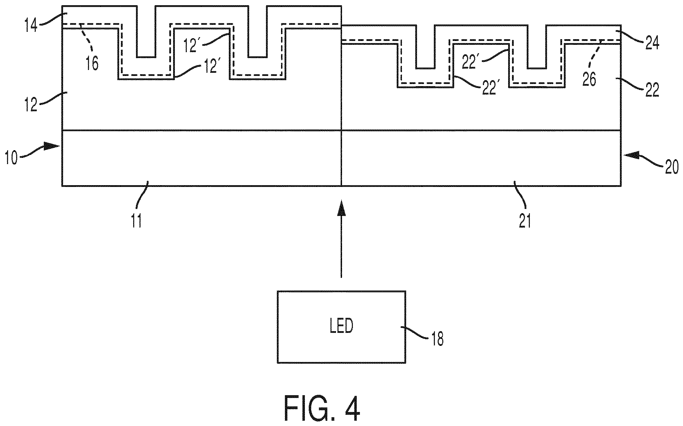

Figure 4 exemplifies another suitable configuration where multiple devices or structures 10 and 20 are nested together, particularly interleaved laterally as depicted. In Figure 4, device 10 includes substrate layer 11 over which is coated polymer layer 12 with recesses 12'. Dielectric layer 14 (e.g. layer comprising TiO₂ or other suitable material such as other metal oxide to provide a desired refractive index differential) is coated over the polymer layer 12. Nanostructure materials 16 such as quantum dots are embedded within the dielectric layer 14 suitably by procedures as disclosed above with respect to Figures 1 and 2. Substrate 21 of device 20 suitably laterally abuts substrate 11 of device 10, although other arrangements also would be suitable such as where substrate 21 abuts polymer layer 12 of device 10. As shown in Figure 4, suitably overlying substrate 21 is polymer layer 22 with recesses 22' and then dielectric layer 24 (e.g. layer comprising TiO₂ or other suitable material such as other metal oxide to provide a desired refractive index differential) is coated over polymer layer 22. Nanostructure materials 26 such as quantum dots are embedded within the dielectric layer 24 suitably by procedures as disclosed above with respect to Figure 1 and 2.

It also can be seen that the configuration of Figures 3 and 4 provides a dielectric layer that comprises first and second nanostructure materials at differing depths within the dielectric layer. The first and second nanostructure materials suitably may be the same or different.

Figure 5 of the drawings shows another exemplary device or structure that includes multiple nanostructure material layers within a single dielectric layer. As shown in Figure 5, device structure 10 includes polymer layer 12 on substrate 11. Layer 12 suitably is replica molded on a molding substrate.

Dielectric material layer 14 is embedded with nanostructure materials 16a, 16b such as light-emitting quantum dots. As with structures exemplified in Figures 1 through 4, layer 14 in Figure 5 provides a refractive index differential with respect to layer 12 to thereby provide effective contrast. Thus, layer 14 may have a refractive index that is lower than the refractive index of layer 12, or layer 14 may have a refractive index that is higher than the refractive index of layer 12. For at least certain applications, preferred materials for the layer 14 include titanium dioxide (TiO₂) or other suitable high refractive index inorganic oxide. Again, layer 14 can be deposited by coating (e.g., spin coating, spray coating, dip coating), sputtering, or other methods for depositing a layer of material on the polymeric layer without disturbing the patterning of the polymeric layer 12. The thickness of the layer 14 can be used to tune the resonant wavelength of the periodic recesses. When the layer 14 is TiO₂, a suitable thickness is from about 50 nm to about 500 nm. Light source 18 can be a suitable LED. Substrate 11 can be made of any rigid or flexible material as described above. Also as described above, the one or more of the polymers of layer 12 can be selected from any suitable polymeric material. Polymer layer 12 suitably can be patterned, e.g. the layer 12 may comprise a plurality of recesses 12'.

The thickness of each portion of a dielectric layer (exemplified as 14a, 14b and 14c in Figure 5) can suitably vary. Each such dielectric layer portion thickness (shown as 14a', 14b', 14c' in Figure 5) can differ and be selected for enhanced emission of interposing nanostructure material layers (exemplified as 16a, 16b in Figure 5). For instance, nanostructure material layer 16a can be positioned a distance 17a from polymer layer 12 by selecting the thickness 14a' of dielectric layer portion 14a. Similarly, nanostructure material layer 16b can be positioned distance 17b from polymer layer 12 by selecting the thicknesses 14a' and 14b' of dielectric layer portions 14a and 14b. Precise deposition of a selected dielectric layer portion thickness can be achieved by a variety of application techniques, including sputtering.

Exemplary suitable dielectric layer portion thicknesses between an underlying substrate surface (such as the thickness between surface 12" of polymer layer 12 and a nanostructure material layer 16) may suitably vary widely and include for example from about 1nm to about 1000 nm, more typically from about 2 or 3 nm to about 100, 150 or 200 nm.

If a device contains multiple nanostructure material layers as show in the exemplary device 10 of Figure 5, multiple nanostructure material layers 16a and 16b are suitably spaced as desired. Exemplary suitable dielectric layer portion thicknesses between sequential nanostructure material layers (i.e., with reference to Figure 5, thickness 14b' between nanostructure material layers 16a and 16b) may suitably vary widely and include for example from about 1 nm to about 1000 nm, more typically from about 2 or 3 nm to about 100, 150 or 200 nm.

After deposition of a layer (e.g. 16a) of nanostructure material, a further dielectric material layer 14b is suitably applied such a sputtering, spin coating, or other technique, with sputtering often being preferred. As discussed, thereafter, one or more additional layers of nanostructure materials such as quantum dots may be applied sequentially as exemplified by nanostructure material layer 16b in Figure 5. Dielectric material is interposed between each nanostructure material layer. Preferably, a dielectric material as exemplified by layer 14c in Figure 5 overcoats a top nanostructure material layer (16b in Figure 5) to thereby embed that nanostructure material within dielectric material.

It also can be seen that the configuration of Figure 5 provides a dielectric layer that comprises first and second nanostructure materials at differing depths within the dielectric layer. The first and second nanostructure materials suitably may be the same or different.

Exemplary suitable top dielectric layer portion thicknesses 14c' between a top nanostructure material layer 16b and top surface 14' of a dielectric layer also may suitably vary widely and include for example from about 1 nm to about 1000 nm, more typically from about 2 or 3 nm to about 100, 150 or 200 nm.

In additional embodiments, multiple photonic crystals having one or more dielectric layers with embedded nanostructure as disclosed herein may be aggregated to provide a larger device structure. For example, such multiple photonic crystal structure may be nested in adjoining configurations, such as stacked, to produce a larger device structure.

In systems and devices of the invention, it also may be suitable to have nanostructure materials nested at other positions, or example of the surface on a dielectric layer, or within polymer layer 12 and/or 22 (as shown in Figures 1, 2, 3, 4 and 5), or other positions within a device, in addition to being embedded within a dielectric layer of the device.

Thicknesses of nanostructure layer(s) of a device (such as thicknesses of layers 16a and/or 16b in Figure 5) also can suitably be a mono-layer as may be provided by dip coating application as disclosed herein generally will be suitable.

As discussed, it has been found that optimal emission output of a nanostructure material layer can be achieved by selection of the location (depth) at which the nanostructure material layer is embedded within a dielectric layer. It has been found that depth placement of light emitting nanostructure materials within a photonic crystal can be used to control both the intensity and angular output of emitted photons.

Thus, by embedding light emitting nanostructure materials at different locations within a photonic crystal structure, tailored lighting outputs can be created. Placement of light emitting nanostructure materials at multiple depths also can be employed to control the angular output of specific wavelengths, creating wide angle viewing that is desirable for instance for screens and shared displays, or a targeted, narrowly angled output to provide for example privacy or depth perception for the viewer.

For a particular light-emitting nanostructure material, an optimal placement location within a dielectric layer can be readily determined empirically. For instance, several samples of a device can be produced with the nanostructure materials positioned at different depths within a dielectric layer and emission outputs of the varied samples evaluated. Different nanostructure materials may have different placement depths within a dielectric layer to provide optimal desired emissions. Peak electric field position of a particular nanostructure material within a dielectric layer can be dependent on the emitting wavelength of the nanostructure material.

As discussed above, in the present structures and methods, polymer layers, nanostructure materials, dielectric material layers and other layers such as a layer having a differing refractive index may be applied by a variety of deposition methods including fluid or liquid applications including liquid dip coating, transfer printing, spin coating, and sputtering, among others.

For producing at least certain structures, dip coating application of nanostructure material layers can be preferred. As referred to herein, dip coating includes partial or complete immersion of a substrate or substrate surface to be coated into a fluid composition to be applied to the immersed surface. Thus, in the case applying a nanostructure material such as quantum dots as disclosed herein, a substrate suitably having a dielectric material layer thereon is at least partially immersed into a fluid composition comprising the nanostructure material. Such dip coating can provide a particularly effective layer of nanostructure materials on the substrate surface. The nanostructure material can be dissolved or dispersed in a fluid organic composition into which a substrate having a dielectric layer thereon is immersed. After such dipping of the substrate, the substrate can be removed from the fluid composition and allowed to dry.

As discussed above, the term "nanostructure material", as used herein, includes quantum dot materials as well as nanocrystalline nanoparticles (nanoparticles or nanocrystals) that comprise one or more heterojunctions such as heterojunction nanorods. Nanostructure materials, including nanocrystals and quantum dots, embrace semiconductor materials having a nanocrystal structure and sufficiently small to display quantum mechanical properties. See U.S. Published Application 2013/0056705 and U.S. Patent 8039847. See also US 2012/0234460 and US 20130051032. Nanostructure materials also may include fluorescent dyes and phosphors including upconverting phosphors.

A quantum dot suitably may be Group II-VI material, a Group III-V material, a Group V material, or a combination thereof. The quantum dot suitably may include e.g. at least one selected from CdS, CdSe, CdTe, ZnS, ZnSe, ZnTe, HgS, HgSe, HgTe, GaN, GaP, GaAs, InP and InAs. Under different conditions, the quantum dot may include a compound including two or more of the above materials. For instance, the compound may include two or more quantum dots existing in a simply mixed state, a mixed crystal in which two or more compound crystals are partially divided in the same crystal e.g. a crystal having a core-shell structure or a gradient structure, or a compound including two or more nanocrystals. For example, the quantum dot may have a core structure with through holes or an encased structure with a core and a shell encasing the core. In such embodiments, the core may include e.g. one or more materials of CdSe, CdS, ZnS, ZnSe, CdTe, CdSeTe, CdZnS, PbSe, AgInZnS, and ZnO. The shell may include e.g. one or more materials selected from CdSe, ZnSe, ZnS, ZnTe, CdTe, PbS, TiO, SrSe, and HgSe.

Passivated nanocrystalline nanoparticles (nanoparticles) that comprise a plurality of heterojunctions suitably facilitate charge carrier injection processes that enhance light emission when used as a device. Such nanoparticles also may be referred to as semiconducting nanoparticles and may comprise a one-dimensional nanoparticle that has disposed at each end a single endcap or a plurality of endcaps that contact the one-dimensional nanoparticle. The endcaps also may contact each other and serve to passivate the one-dimensional nanoparticles. The nanoparticles can be symmetrical or asymmetrical about at least one axis. The nanoparticles can be asymmetrical in composition, in geometric structure and electronic structure, or in both composition and structure. The term heterojunction implies structures that have one semiconductor material grown on the crystal lattice of another semiconductor material. The term one-dimensional nanoparticle includes objects where the mass of the nanoparticle varies with a characteristic dimension (e.g. length) of the nanoparticle to the first power. This is shown in the following formula (1): M α Ld where M is the mass of the particle, L is the length of the particle and d is an exponent that determines the dimensionality of the particle. Thus, for instance, when d = 1, the mass of the particle is directly proportional to the length of the particle and the particle is termed a one-dimensional nanoparticle. When d = 2, the particle is a two-dimensional object such as a plate while d = 3 defines a three-dimensional object such as a cylinder or sphere. The one-dimensional nanoparticles (particles where d = 1) includes nanorods, nanotubes, nanowires, nanowhiskers, nanoribbons and the like. In one embodiment, the one-dimensional nanoparticle may be cured or wavy (as in serpentine), i.e. have values of d that lie between 1 and 1.5. Exemplary preferred materials are disclosed in U.S. Patent 8,937,294.

The one-dimensional nanoparticles suitably have cross-sectional area or a characteristics thickness dimension (e.g., the diameter for a circular cross-sectional area or a diagonal for a square of square or rectangular cross-sectional area) of about 1 nm to 10000 nanometers (nm), preferably 2 nm to 50 nm, and more preferably 5 nm to 20 nm (such as about 6, 7, 8, 9, 10, 11, 12, 13, 14, 15, 16, 17, 18, 19 or 20 nm) in diameter. Nanorods are suitably rigid rods that have circular cross-sectional areas whose characteristic dimensions lie within the aforementioned ranges. Nanowires or nanowhiskers are curvaceous and have different or vermicular shapes. Nanoribbons have cross-sectional area that is bounded by four or five linear sides. Examples of such cross-sectional areas are square, rectangular, parallelopipeds, rhombohedrals, and the like. Nanotubes have a substantially concentric hole that traverses the entire length of the nanotube, thereby causing it to be tube-like. The aspect ratios of these one-dimensional nanoparticles are greater than or equal to 2, preferably greater than or equal to 5, and more preferably greater than or equal to 10.

The one-dimensional nanoparticles comprise semiconductors that suitably include those of the Group II-VI (ZnS, ZnSe, ZnTe, CdS, CdTe, HgS, HgSe, HgTe, and the like) and III-V (GaN, GaP, GaAs, GaSb, InN, InP, InAs, InSb, AlAs, AlP, AlSb, and the like) and IV (Ge, Si, Pb and the like) materials, an alloy thereof, or a mixture thereof.

Nanostructure materials including quantum dot materials are commercially available and also may be prepared for example by a standard chemical wet method using a metallic precursor as well as by injecting a metallic precursor into an organic solution and growing the metallic precursor. The size of the nanostructure material including quantum dot may be adjusted to absorb or emit light of red (R), green (G), and blue (B) wavelengths. Thus, a light-emitting nanocrystal may be selected to absorb or emit light of a selected wavelength or wavelength range.

The following examples are illustrative of the invention.

### Materials and methods for Example 1 which follows:

*Device fabrication:* In these examples, photonic crystal (PC) fabrication utilized a "master" silicon wafer containing a negative image of the desired replica molded structure for the PC grating. The mold contained a thermal oxide SiO₂ layer with electron beam lithography (JEOL JBX-6000FS) patterning to produce 80 nm pillars with reactive ion etching (PlasmaLab Freon/O₂ Reactive Ion Etcher). The etched area was cleaned for 20 min with a solution of piranha etchant (3:1 (v/v) mixture of sulfuric acid and hydrogen peroxide), then rinsed with de-ionized water, dried with N₂ and treated for 1 hr with a vapor phase deposition of (tridecafluoro-1,1,2,2-tetrahydrooctyl) trichlorosilane (No-Stick, Alfa Aesar) in a closed container with two drops of No-Stick solution. The post etch processing enables the consistent removal of the replica from the master wafer.

The replica molded layer of the PC was formed with a UV curable polymer that contained 91 µL of Lauryl methacrylate (LMA) and 9 µL of ethylene glycol dimethacrylate (EGDMA) mixed in a flask, followed by the addition of 1 µL of initiator (Darocur 1173, Sigma-Aldrich). The solution was drop-coated onto the master wafer, and covered by a sheet of Optigrafix Acetate, that had been previously treated with a vapor phase deposition of 3-(trimethoxysilyl)propyl methacrylate (Sigma Aldrich) to increase the polymer adhesion. The droplet spread and formed a continuous thin layer between the silicon substrate and acetate sheet. It was polymerized under a high intensity UV lamp for 30 min in an argon atmosphere, and then the film containing the replicated grating structure attached to the acetate substrate and could be removed from the master.

Sputtering was used to deposit the desired thickness of the high refractive index TiO₂ layer (K. J. Lesker Dual-Gun Sputter System) over the replica molded polymer layer. A cadmium selenide (CdSe) quantum dot (QD) dip coating solution was synthesized with an oleic acid ligand coating, purified twice by precipitation and centrifugation with ethanol and methanol, and then redispersed in hexane at the original concentration. The PC was dipped into the solution for 15 sec, removed and allowed to dry for at least 5 min. If the deposition was not uniform, the PC can be soaked in hexane to remove the quantum dots and the dipping procedure be repeated. Finally, hexane was used to remove QDs from the back surface of the substrate to eliminate any confounding emission outside the PC device area. Additional sputtering was then performed to complete the TiO₂ layer.

### Measurement and characterization:

The test setup used to characterize the output of each test structure was operated by a LabVIEW OmniDriver interface. The excitation source for the QDs is a collimated UV light emitting diode (Thor Labs, Ultra Bright Deep Violet LED) with a center wavelength of λ=375 nm. The LED has a full-width, half-maximum of 20 nm and a 350<λ<390 nm bandpass filter was also used to eliminate any non-UV wavelengths from reaching the structure under test and interfering with the measurement of the QD emission. For testing, the structure was mounted on a motorized rotation stage, which allows for 0.1° step increments in the orientation of the structure's surface to the optical axis of the test setup. The output emission at each position was collected after passing through a UV filter and collimating lens on an optical fiber, and then analyzed by a USB2000+ Ocean Optics spectrometer.

By using a broadband, unpolarized tungsten-halogen lamp as the source (replacing the LED and bandpass filter), the transmission spectra through the structures could also be measured. The illumination source was passed through a bulk sample that had experienced identical processing to the photonic crystal test structure, providing a control measurement for light attenuation through the various layers. Identical measurements were then taken of the test structures, and normalized with the control measurements, to determine the photonic band structures and the angular dependence of the output emission.

### Example 1: Device fabrication

The device structure produced includes two distinct 2-dimensional PC regions that enable side-by-side comparison of QD emission intensity from regions that either match or mismatch the PC resonant wavelength with the emission wavelength of embedded QDs. As shown in Figure 6(a), the regions were interleaved in a checkerboard format, in which alternating regions have distinct resonance wavelengths. Each region had two orthogonal periods, as shown in the inset of Figure 6(a), and the two periods were designed to enhance both the excitation and emission wavelengths of embedded QDs. For example, the 2D-PC in Region 1 of the checkerboard has a short period (*L*=200 nm, 40% duty cycle) in the x-direction and a longer period (*L*=340 nm) in the y-direction. The short period is designed to produce a guided mode resonance at the UV wavelengths of 350<λ<390 nm used for QD excitation, while the longer period is designed to produce a resonance at the λ=615 nm wavelength of QD emission. Region 4 of the checkerboard has a short period of *L*=200 nm (70% duty cycle) in the x-direction and a long period of *L*=250 nm in the y-direction, where the short period is also designed to produce a guided mode resonance at the QD excitation wavelength, but the long period produces a resonance at a wavelength of λ=480 nm. Therefore, when QDs with an emission wavelength centered at λ=615 nm are embedded within the entire structure, all the QDs (in both parts of the checkerboard) will be excited with a resonant enhancement effect, but only QDs within Region 1 will participate in the enhanced extraction effect. Finite difference time domain electromagnetic computer simulation (Lumerical, FDTD) was used to determine that a 95 nm thickness of TiO₂ (n=2.35, Metricon Model 2010/M Prism Coupler) layer would optimize coupling to unpolarized QD emission at λ=615 nm. This was consistent with values extrapolated from the resonance conditions in previous PC devices fabricated using the same grating structure but alternate deposition thicknesses of the TiO₂ layer.

The region with a resonance targeted to enhance the λ=615 nm QD emission has a 340 nm period with a 60% duty cycle and an orthogonal grating with a period of 140 nm with a 70% duty cycle. The alternate PC checkerboard region has an optical resonance at a shorter wavelength of λ=490 nm, but it does not overlap with the QD emission, and halves the effective device area providing QD emission enhancement. The difference in output intensity is visible to the naked eye and enables a visual confirmation of QD enhancement, as shown in the photograph of a QD embedded PC in Figure 6(e). To simplify this study, the optical characteristics near the λ=615 nm resonance are the focus of the results.

As shown in Figure 6(b), the PC had a replica molded polymer grating structure over which a specific thickness, *h*, of TiO₂ is deposited. A layer of QDs is then applied by dip-coating over the TiO₂ surface, and the remainder of the desired TiO₂ thickness is deposited over the QDs. An SEM image of the top surface after the final TiO₂ deposition is shown in Figure(c). The modeled electric field for resonant modes at λ=615 nm and λ=550 nm are shown in Figure 6(d), demonstrating that the location of the peak electric field intensity changes with the incident wavelength within the same PC structure. By varying the depth of the QD emitters within the TiO₂ layer, we anticipate that enhancement of the QD emission intensity will also vary. To investigate the impact of the QD placement within the TiO₂ region, we fabricated devices with the configurations described in the following Table 1, with each batch comprised of three PC samples and a flat "control" sample that was created with the same procedure, but without the periodic grating structure.

**Table 1.**

| The thickness of each TiO₂ layer, and thus the placement of the QD layers, for each batch of test structures. | | | | |
|---|---|---|---|---|
| Batch | Layer 1 | Layer 2 | Layer 3 | Layer 4 |
| 1 | Replica molded polymer | 30 nm TiO₂ | QD | 65 nm TiO₂ |
| 2 | Replica molded polymer | 60 nm TiO₂ | QD | 35 nm TiO₂ |
| 3 | Replica molded polymer | 90 nm TiO₂ | QD | 5 nm TiO₂ |

The transmission efficiency spectra of the devices were measured after each stage of the fabrication process as described above. The minimum value of the measured transmission efficiency at normal incidence was used to determine the reported wavelength of the resonance mode. The modeled transmission efficiency for a continuous TiO₂ dielectric layer, shown as the black line in Figure 7 was normalized for the 50% effective area of the checkerboard pattern used for comparison with the measured transmission spectra.

As shown in Figure 7 of the drawings, each layer of deposited TiO₂ material caused a red-shift in the transmission efficiency minimum. There was also a shift of λ=20-25 nm caused by the addition of the QDs observed in every sample. For those structures with the QDs added at *h*=90 nm, with only 5 nm of TiO₂ deposited over the QD layer, the transmission efficiency minimum occurred at λ=620 nm. This minimum occurs at a wavelength only Δλ=5 nm greater than λ=615 nm value predicted by the modeled results for a continuous dielectric layer with no embedded QDs. However, for the other device conditions, after the final TiO₂ layer was deposited over the QDs the resonance wavelengths for the other depths *h* are blueshifted from the modeled wavelength by Δλ=40 nm for *h*=30 nm and by Δλ=15 nm for *h*=60 nm. In these PCs, the continuous refractive index of the TiO₂ layer is disrupted and the effective refractive index of the PC is altered by the higher refractive index material of the QDs (*n*=2.5-2.64, depending on size. The impact of the QDs on the refractive index varies with their location within high or low intensity portions of the electric field, further modifying the effective refractive index of the photonic crystal.

The output intensities of the fabricated devices were also measured across a range of angles, and the impact of the QD location within the dielectric layer in relation to the enhancement of the QD emission was determined. Because the resonance is dependent on both the extraction angle and wavelength of the light coupling out of the PC, the output intensity, as shown in Figure 8 of the drawings, was measured across a range of angles from normal incidence (0°) to 20° at the peak QD emission of λ=615 nm. The output intensity was averaged for the three PC structures measured in each experimental condition. The enhancement factor was determined by dividing the average QD output intensity within the PC by the planar control structure output intensity for each experimental condition. The actual enhancement factors for the checkerboard regions with a resonance matched to the emission wavelength of the QD will actually be 2X higher than the values we report here, because the QD emission in the alternate checkerboard regions are not enhanced.

Figure 8 of the drawings clearly shows that the depth of the embedded QDs within the dielectric layer of photonic crystals impacts the enhancement of the QD emission. The highest enhancement factor at normal incidence was 5X and occurred in the structure with a QD layer closest to the TiO₂ surface, placed at a depth *h*=90 nm. This is expected from on the modeled results for λ=615 nm light extracted at normal incidence, shown in Figure 6(d) of the drawings, where the greatest electric field is concentrated along the top surface of the high refractive index layer. However, other fabricated structures demonstrated higher enhancement factors (up to 8X) at an extraction angle of 4° for QDs placed at *h*=60 nm of TiO₂, and 7° for QDs at *h*=30 nm.

As discussed, the varied angle at which the peak enhancement occurs indicates that the depth placement of emitters within PCs can be used to control both the intensity and angular output of emitted photons. This methodology would be useful to simultaneously enhance multiple QD emission wavelengths embedded at different locations within the PC structure and create tailored lighting outputs. Placement of QDs at multiple depths could also be used to specifically control the angular output of specific wavelengths, creating wide angle viewing that is desirable for screens and shared displays, or a targeted, narrowly angled output to provide privacy or depth perception for the viewer.

## Claims

1. A structure (10) comprising:
multiple photonic crystals nested together,
each photonic crystal comprising a dielectric layer (14a, 14b),
the dielectric layer (14a, 14b) comprising therein light-emitting nanostructure materials (16),
wherein a first set of light-emitting nanostructure materials (16) is positioned at a first depth level of the dielectric layer (14a), and a second set of light-emitting nanostructure materials is positioned at a second depth level of the dielectric layer (14b) that is distinct from the first depth level (14a),
wherein the emission wavelengths differ between the first and second sets of light-emitting nanostructure materials (16).

2. The structure (10) of claim 1 wherein the light-emitting nanostructure materials are embedded within the dielectric layer (14a, 14b).

3. The structure (10) of claim 1 or 2 wherein the dielectric layer (14a) comprises a metal oxide.

4. The structure (10) of any one of claim 1 through 3 wherein the nanostructure materials (16) comprise quantum dots, fluorescent dyes, or phosphors.

5. The structure (10) of any one of claims 1 through 4 wherein the structure (10) provides a light-emitting device, a photodetector device, a chemical sensor, a photovoltaic device, a fluorescent backlight film, a diode, a transistor, a biological sensor, a pathological detector or a biologically active surface.

6. A method of forming a photonic crystal system, comprising:
applying on a substrate (11) surface a first dielectric material (14a);
applying one or more nanostructure materials (16) on the applied dielectric material, and
applying a dielectric material over the applied nanostructure materials (16);
wherein said photonic crystal system comprises multiple photonic crystal structures nested together, each photonic crystal structure comprising a dielectric layer (14a) comprising within the dielectric layer (14a) one or more light-emitting nanostructure materials (16),
wherein a first set of light-emitting nanostructure materials (16) is positioned at a first depth level of the dielectric layer (14a), and a second set of light-emitting nanostructure materials is positioned at a second depth level of the dielectric layer (14b) that is distinct from the first depth level (14a), wherein the emission wavelengths differ between the first and second sets of light-emitting nanostructure materials (16).

7. The method of claim 6 wherein the first dielectric material (14a) is applied by dip coating.

## Patentansprüche

1. Struktur (10), umfassend:
mehrere photonische Kristalle, welche miteinander verschachtelt sind,
wobei jeder photonische Kristall eine dielektrische Schicht (14a, 14b) umfasst;
wobei die dielektrische Schicht (14a, 14b) lichtemittierende Nanostrukturmaterialien (16) darin umfasst;
wobei ein erster Satz von lichtemittierenden Nanostrukturmaterialien (16) an einem ersten Tiefenniveau der dielektrischen Schicht (14a) angeordnet ist und ein zweiter Satz von lichtemittierenden Nanostrukturmaterialien an einem zweiten Tiefenniveau der dielektrischen Schicht (14b) angeordnet ist, welches von dem ersten Tiefenniveau (14a) unterschiedlich ist,
wobei die Emissionswellenlängen des ersten und des zweiten Satzes von lichtemittierenden Nanostrukturmaterialien (16) unterschiedlich sind.

2. Struktur (10) nach Anspruch 1, wobei die lichtemittierenden Nanostrukturmaterialien innerhalb der dielektrischen Schicht (14a, 14b) eingebettet sind.

3. Struktur (10) nach Anspruch 1 oder 2, wobei die dielektrische Schicht (14a) ein Metalloxid umfasst.

4. Struktur (10) nach einem der Ansprüche 1 bis 3, wobei die Nanostrukturmaterialien (16) Quantendots, Fluoreszenzfarbstoffe oder Leuchtstoffe umfassen.

5. Struktur (10) nach einem der Ansprüche 1 bis 4, wobei die Struktur (10) eine lichtemittierende Vorrichtung, eine Photodetektorvorrichtung, einen chemischen Sensor, eine Photovoltaikvorrichtung, einen fluoreszierenden Rücklichtfilm, eine Diode, einen Transistor, einen biologischen Sensor, einen Pathologiedetektor oder eine biologisch aktive Oberfläche umfasst.

6. Verfahren zum Bilden eines photonischen Kristallsystems, umfassend:
Aufbringen eines ersten dielektrischen Materials (14a) auf einer Oberfläche eines Substrats (11);
Aufbringen eines oder mehrerer Nanostrukturmaterialien (16) auf dem aufgebrachten dielektrischen Material, und
Aufbringen eines dielektrischen Materials über die aufgebrachte Nanostrukturmaterialien (16);
wobei das photonische Kristallsystem mehrere photonische Kristallstrukturen umfasst, welche miteinander verschachtelt sind, wobei jede photonische Kristallstruktur eine dielektrische Schicht (14a) umfasst, welche innerhalb der dielektrischen Schicht (14a) ein oder mehrere lichtemittierende Nanostrukturmaterialien (16) umfasst,
wobei ein erster Satz von lichtemittierenden Nanostrukturmaterialien (16) an einem ersten Tiefenniveau der dielektrischen Schicht (14a) angeordnet ist und ein zweiter Satz von lichtemittierenden Nanostrukturmaterialien an einem zweiten Tiefenniveau der dielektrischen Schicht (14b) angeordnet ist, welches von dem ersten Tiefenniveau (14a) unterschiedlich ist, wobei die Emissionswellenlängen des ersten und des zweiten Satzes von lichtemittierenden Nanostrukturmaterialien (16) unterschiedlich sind.

7. Verfahren nach Anspruch 6, wobei das erste dielektrische Material (14a) durch Tauchbeschichten aufgebracht wird.

## Revendications

1. Structure (10), comprenant :
de multiples cristaux photoniques imbriqués les uns dans les autres ;
chaque cristal photonique comprenant une couche diélectrique (14a, 14b) ;
la couche diélectrique (14a, 14b) comprenant des matériaux à nanostructure émetteurs de lumière (16) ;
dans laquelle un premier ensemble de matériaux à nanostructure émetteurs de lumière (16) est positionné à un premier niveau de profondeur de la couche diélectrique (14a), un deuxième ensemble de matériaux à nanostructure émetteurs de lumière étant positionné à un deuxième niveau de profondeur de la couche diélectrique (14a), distinct du premier niveau de profondeur (14a) ;
dans laquelle les longueurs d'onde démission diffèrent entre les premier et deuxième ensembles de matériaux à nanostructure émetteurs de lumière (16).

2. Structure (10) selon la revendication 1, dans laquelle les matériaux à nanostructure émetteurs de lumière sont noyés dans la couche diélectrique (14a, 14b).

3. Structure (10) selon la revendication 1 ou 2, dans laquelle la couche diélectrique (14a) comprend un oxyde métallique.

4. Structure (10) selon l'une quelconque des revendications 1 à 3, dans laquelle les matériaux à nanostructure (16) comprennent des points quantiques, des colorants fluorescents ou des phosphores.

5. Structure (10) selon l'une quelconque des revendications 1 à 4, dans laquelle la structure (10) fournit un dispositif émetteur de lumière, un dispositif photodétecteur, un capteur chimique, un dispositif photovoltaïque, un film à rétroéclairage fluorescent, une diode, un transistor, un capteur biologique, un détecteur pathologique ou une surface biologiquement active.

6. Procédé de formation d'un système de cristal photonique, comprenant les étapes ci-dessous :
application d'un premier matériau diélectrique (14a) sur une surface de substrat (11) ;
application d'un ou de plusieurs matériaux à nanostructure (16) sur le matériau diélectrique appliqué ; et
application d'un matériau diélectrique au-dessus des matériaux à nanostructure appliqués (16) ;
dans lequel ledit système de cristal photonique comprend de multiples structures de cristal photoniques imbriquées les unes dans les autres, chaque structure de cristal photonique comprenant une couche diélectrique (14a) comprenant dans la couche diélectrique (14a) un ou plusieurs matériaux à nanostructure émetteurs de lumière (16) ;
dans lequel un premier ensemble de matériaux à nanostructure émetteurs de lumière (16) est positionné à un premier niveau de profondeur de la couche diélectrique (14a), et un deuxième ensemble de matériaux à nanostructure émetteurs de lumière étant positionné à un deuxième niveau de profondeur de la couche diélectrique (14b), distinct du premier niveau de profondeur (14a), dans lequel les longueurs d'onde d'émission diffèrent entre les premier et deuxième ensembles de matériaux à nanostructure émetteurs de lumière (16).

7. Procédé selon la revendication 6, dans lequel le premier matériau diélectrique (14a) est appliqué par revêtement au trempé.
